# EUROPEAN PATENT SPECIFICATION

(11) **EP 4 496 440 B1**
(45) Date of publication and mention of the grant of the patent: **15.04.2026**
(21) Application number: 22937211.5
(22) Date of filing: 03.11.2022
(51) Int. Cl.: H05K 7/20, F28D 15/02, F28D 15/04

(54) **TWO-PHASE RADIATING FIN AND HEAT SINK**
ZWEIPHASIGE STRAHLUNGSRIPPE UND KÜHLKÖRPER
AILETTE RAYONNANTE À DEUX PHASES ET DISSIPATEUR THERMIQUE

(30) Priority: 14.04.2022 CN 202210390450
(43) Date of publication of application: 22.01.2025
(73) Proprietor: ZTE Corporation, Shenzhen, Guangdong 518057 (CN)
(72) Inventor: DUAN, Kaiwen, Shenzhen, Guangdong 518057 (CN); NIE, Zhidong, Shenzhen, Guangdong 518057 (CN); CHU, Wenxiao, Shenzhen, Guangdong 518057 (CN); TAN, Zhoutuo, Shenzhen, Guangdong 518057 (CN); LIU, Xin, Shenzhen, Guangdong 518057 (CN); WANG, Yan, Shenzhen, Guangdong 518057 (CN); LI, Shuai, Shenzhen, Guangdong 518057 (CN)
(74) Representative: WBH Wachenhausen Patentanwälte PartG mbB
(86) International application number: PCT/CN2022/129582
(87) International publication number: WO 2023/197578

(56) References cited:
- EP-A1- 3 933 336
- CN-A- 103 822 516
- CN-A- 111 207 612
- CN-A- 113 028 869
- CN-U- 213 873 936
- US-A1- 2019 124 791

## Description

### TECHNICAL FIELD

The present disclosure relates to the technical field of heat dissipation, and more particularly, to a two-phase heat dissipation fin and a heat sink.

### BACKGROUND

With the rapid advancement of electronic technologies, electronic devices are increasingly being developed with larger capacities, higher power, greater integration, and lighter weight, which leads to a rise in heat consumption density of device systems and increased requirements for environmental adaptability. The challenge of ensuring reliable heat dissipation in electronic devices has gradually become a bottleneck, hindering the development of various related industries.

To address the problem of high-density heat consumption, it is urgent to develop a heat dissipation structure that can not only meet heat dissipation requirements of high-heat-flux and high-power modules, but also be efficient, reliable, and lightweight. As a new-type enhanced heat transfer element, a two-phase heat dissipation fin removes heat through latent heat, which has more outstanding heat transfer performance while maintaining a compact size, has great application prospects, and can be widely used in various military and civilian industries. With its characteristics of high thermal conductivity and stable average temperature, the two-phase heat dissipation fin is gradually replacing traditional metal fins in conventional heat sinks.

However, related two-phase heat dissipation fins face challenges in industrial application processes that gas and liquid flow channels inside the fins are mixed, two-phase circulation driving force is weak, and self-circulation cannot be formed. As a result, the circulation and heat dissipation efficiency of these fins still require further improvement.

EP3933336A1 relates to a heat exchanger comprising a plurality of heat exchanger fins and a base plate according to the preamble of claim 1. Each heat exchanger fin comprises a first portion and second portion having channels therein. The channels are formed by at least a first and second metal sheet. The channels are under vacuum and have a working fluid therein. The channels increase the rate of convective heat transfer to or from an environment by evaporation of a working fluid which is spread by a vapor flow filling the vacuum. The vapor flow eventually condenses over cooler surfaces, distributing heat from a heat source to a larger condensation cooling surface area. An at least a second portion increases the surface area of the heat source in thermal contact with the heat exchanger, thus, further increasing the rate of convective heat transfer while not increasing the square area allotted for the heat exchanger.

### SUMMARY

The invention is set out in the appended set of claims.

Embodiments of the present disclosure provide a two-phase heat dissipation fin and a heat sink.

In accordance with a first aspect, an embodiment of the present disclosure provides a two-phase heat dissipation fin. The two-phase heat dissipation fin includes: a heat dissipation tooth plate, having a near heat source side and a far heat source side; a circumferential loop channel, arranged on the heat dissipation tooth plate, where the circumferential loop channel is filled with a phase-change working medium, and the circumferential loop channel includes an evaporation channel arranged on the near heat source side; and a splitting channel, extending obliquely upwards from a lower portion of the evaporation channel to an upper portion of the evaporation channel or extending to a position beyond the evaporation channel.

In accordance with a second aspect, an embodiment of the present disclosure provides a heat sink. The heat sink includes the two-phase heat dissipation fin according to the first aspect.

Other features and advantages of the present disclosure will be set forth in the following description, some of which will be apparent from the description or understood by practicing the present disclosure. The objectives and other advantages of the present disclosure can be implemented and obtained by the structures particularly specified in the description, claims, and accompanying drawings.

### BRIEF DESCRIPTION OF DRAWINGS

The accompanying drawings are used to provide a further understanding of the technical schemes of the present disclosure, which constitute a part of the description, and are used together with the embodiments of the present disclosure to illustrate the technical schemes of the present disclosure, but do not constitute a limitation on the technical schemes of the present disclosure.
FIG. 1 is a schematic diagram of a two-phase heat dissipation fin according to an embodiment of the present disclosure;
FIG. 2 is a schematic diagram of a circumferential loop channel of the two-phase heat dissipation fin in FIG. 1;
FIG. 3 is a schematic diagram of a two-phase heat dissipation fin according to another embodiment of the present disclosure;
FIG. 4 is a schematic diagram of a two-phase heat dissipation fin according to another embodiment of the present disclosure; and
FIG. 5 is a schematic diagram of a two-phase heat dissipation fin according to another embodiment of the present disclosure.

### Reference numerals:

heat dissipation tooth plate 100; circumferential loop channel 110; evaporation channel 111; condensation channel 112; liquid return channel 113; liquid replenishment channel 114; splitting channel 120; splitting center 121; first splitting branch 122; second splitting branch 123; liquid absorbing wick 130; liquid storage structure 140; stepped platform 150; heat source 160; liquid-phase working medium 170; and gas-phase working medium 180.

### DETAILED DESCRIPTION

To make the objectives, technical schemes, and advantages of the present disclosure clear and comprehensible, the present disclosure is further described in detail in conjunction with the accompanying drawings and embodiments. It should be understood that the embodiments described herein are used only to illustrate the present disclosure, and are not intended to limit the present disclosure.

It should be understood that in the description of the embodiments of the present disclosure, the terms such as "first", "second" and the like used herein are merely used for distinguishing technical features, and are not intended to indicate or imply relative importance, or implicitly point out the number of the indicated technical features, or implicitly point out a precedence order of the indicated technical features. The term "at least one" means one or more, and the term "a plurality of" means two or more. The term "and/or" is used for describing an association between associated objects and representing that three associations may exist. For example, "A and/or B" may indicate that only A exists, only B exists, and both A and B exist, where A and B may be singular or plural. The character "/" generally indicates an "or" relation between the associated objects. "At least one of" and similar expressions refer to any combination of items listed, including one item or any combination of a plurality of items. For example, at least one of a, b, and c may represent a, b, c, "a and b", "a and c", "b and c", or "a, b, and c", where a, b, and c may be singular or plural.

In addition, the technical features involved in the embodiments of the present disclosure described below can be combined with each other if not in collision.

With the rapid advancement of electronic technologies, electronic devices are increasingly being developed with larger capacities, higher power, greater integration, and lighter weight, which leads to a rise in heat consumption density of device systems and increased requirements for environmental adaptability. The challenge of ensuring reliable heat dissipation in electronic devices has gradually become a bottleneck, hindering the development of various related industries.

To address the problem of high-density heat consumption, it is urgent to develop a heat dissipation structure that can not only meet heat dissipation requirements of high-heat-flux and high-power modules, but also be efficient, reliable, and lightweight. As a new-type enhanced heat transfer element, a two-phase heat dissipation fin removes heat through latent heat, which has more outstanding heat transfer performance while maintaining a compact size, has great application prospects, and can be widely used in various military and civilian industries. With its characteristics of high thermal conductivity and stable average temperature, the two-phase heat dissipation fin is gradually replacing traditional metal fins in conventional heat sinks.

However, related two-phase heat dissipation fins face challenges in industrial application processes that gas and liquid flow channels inside the fins are mixed, two-phase circulation driving force is weak, and self-circulation cannot be formed. As a result, the circulation and heat dissipation efficiency of these fins still require further improvement.

In view of the above, in accordance with a first aspect of the embodiments of the present disclosure, a two-phase heat dissipation fin is provided, which can implement directional two-phase self-driven circulation of the fin to significantly improve circulation efficiency and heat dissipation efficiency of the fin.

The two-phase heat dissipation fin and heat sink according to the embodiments of the present disclosure are described below with reference to the accompanying drawings.

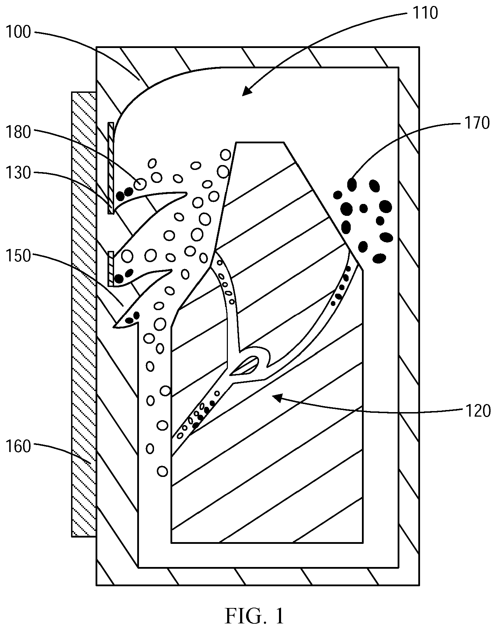

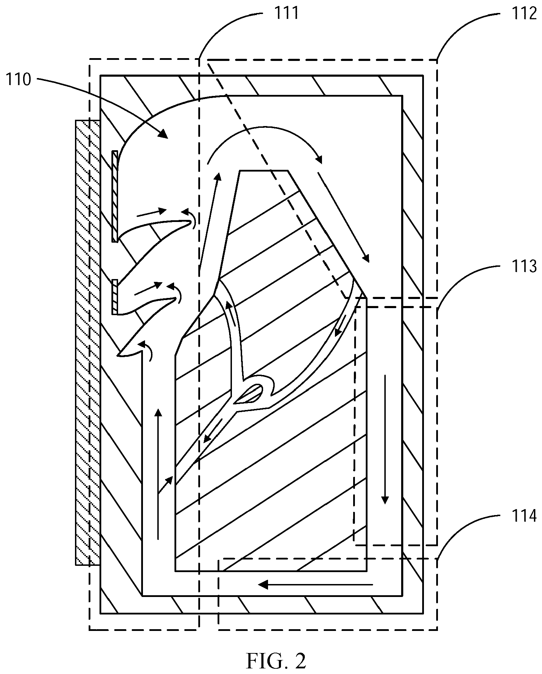

With reference to FIG. 1 and FIG. 2, a two-phase heat dissipation fin according to an embodiment of the present disclosure includes:
a heat dissipation tooth plate 100, a circumferential loop channel 110, and a splitting channel 120. The heat dissipation tooth plate 100 has a near heat source side and a far heat source side. The circumferential loop channel 110 is arranged on the heat dissipation tooth plate 100. The circumferential loop channel 110 is filled with a phase-change working medium, and includes an evaporation channel 111 arranged on the near heat source side. The splitting channel 120 extends obliquely upwards from a lower portion of the evaporation channel 111 to an upper portion of the evaporation channel 111 or extends to a position beyond the evaporation channel 111.

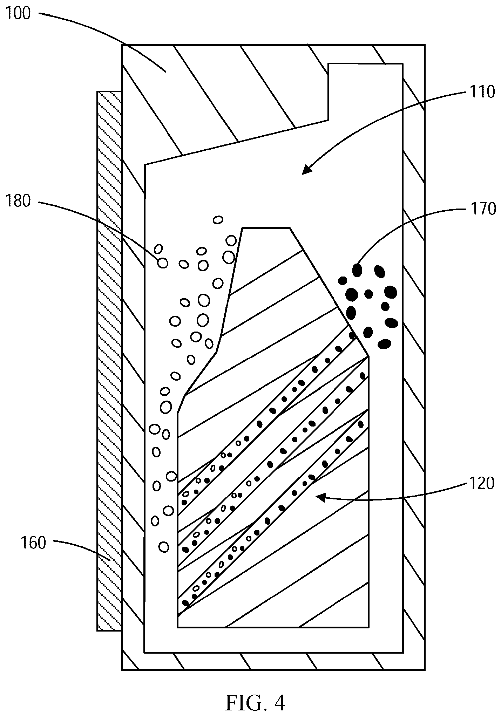

In some embodiments, as shown in FIG. 4, the splitting channel 120 is an inclined pipe extending obliquely upwards from the lower portion of the evaporation channel 111.

In some other embodiments, the splitting channel 120 is a curved pipe extending obliquely upwards from the lower portion of the evaporation channel 111.

It can be understood that the phase-change working medium is classified into a liquid-phase working medium 170 and a gas-phase working medium 180. The liquid-phase working medium 170 and the gas-phase working medium 180 are liquid and gas forms of the phase-change working medium under different working conditions, such as condensate and hot steam. That is, the liquid-phase working medium 170 in the circumferential loop channel 110 absorbs heat from the evaporation channel 111 to evaporate into the gas-phase working medium 180, which flows into a channel on the far heat source side and condenses into the liquid-phase working medium 170. In this way, the phase-change working medium forms directional two-phase circulation in the circumferential loop channel 110.

It can also be understood that "the splitting channel 120 extends upwards from a lower portion of the evaporation channel 111 to an upper portion of the evaporation channel 111 or extends to a position beyond the evaporation channel 111" includes the following cases.

In some embodiments, the splitting channel 120 extends obliquely upwards from the lower portion of the evaporation channel 111 only to the upper portion of the evaporation channel 111. Such an arrangement of the splitting channel 120 can increase discharge paths of the gas-phase working medium 180 and reduce discharge resistance of the gas-phase working medium 180.

In some embodiments, the splitting channel 120 extends obliquely upwards from the lower portion of the evaporation channel 111 only to a position beyond the evaporation channel 111, that is, extends to a channel position in the circumferential loop channel 110 beyond the evaporation channel 111. Such an arrangement of the splitting channel 120 can increase discharge paths of the gas-phase working medium 180, reduce discharge resistance of the gas-phase working medium 180, and increase return paths of the liquid-phase working medium 170.

In some embodiments, the splitting channel 120 extends obliquely upwards from the lower portion of the evaporation channel 111 to the upper portion of the evaporation channel 111 and extends to a position beyond the evaporation channel 111. Such an arrangement of the splitting channel 120 can increase discharge paths of the gas-phase working medium 180, reduce discharge resistance of the gas-phase working medium 180, and increase return paths of the liquid-phase working medium 170. Further, the splitting channel 120 is connected to the lower portion of the evaporation channel 111, the upper portion of the evaporation channel 111, and the position beyond the evaporation channel 111, which can implement gas-liquid separation in the splitting channel 120, such that the discharge paths of the gas-phase working medium 180 and the return paths of the liquid-phase working medium 170 can be more clearly directed, thereby improving two-phase circulation efficiency.

In short, the splitting channel 120 extends obliquely upwards from the lower portion of the evaporation channel 111 to at least one of the upper portion of the evaporation channel 111 and a position beyond the evaporation channel 111.

It should be noted that the lower portion of the evaporation channel 111 refers to a channel below a liquid level of the liquid-phase working medium 170 in the evaporation channel 111, and the upper portion of the evaporation channel 111 may be a channel below the liquid level of the liquid-phase working medium 170 in the evaporation channel 111, or may be a channel above the liquid level of the liquid-phase working medium 170 in the evaporation channel 111, provided that the upper portion of the evaporation channel 111 is above the lower portion of the evaporation channel 111.

The two-phase heat dissipation fin according to this embodiment of the present disclosure has at least the following beneficial technical effects.

The two-phase heat dissipation fin according to this embodiment of the present disclosure includes a heat dissipation tooth plate 100, a circumferential loop channel 110, and a splitting channel 120. The heat dissipation tooth plate 100 has a near heat source side and a far heat source side. The circumferential loop channel 110 is arranged on the heat dissipation tooth plate 100, is filled with a phase-change working medium, and includes an evaporation channel 111 arranged on the near heat source side. The phase-change working medium absorbs heat from the evaporation channel 111 on the near heat source side and condenses on the far heat source side, and the phase-change working medium forms directional two-phase circulation in the circumferential loop channel 110. The splitting channel 120 extends obliquely upwards from a lower portion of the evaporation channel 111 to an upper portion of the evaporation channel 111 or extends to a position beyond the evaporation channel 111, which improves two-phase circulation driving force. In this embodiment of the present disclosure, with the arrangement of circumferential loop channel 110 and the splitting channel 120, stable gas-liquid circulation and strong circulation driving force are formed inside the fin, directional two-phase self-driven circulation of the fin is implemented, and circulation efficiency and cooling efficiency of the fin are improved.

In some embodiments, the evaporation channel 111 is a vertical channel. It can be understood that the liquid-phase working medium 170 absorbs heat and evaporates in the evaporation channel 111. With the evaporation channel 111 arranged as a vertical channel, the gas-phase working medium 180 generated after the liquid-phase working medium 170 evaporates can be discharged upwards along the vertical evaporation channel 111 by buoyancy lift, which reduces flow resistance of the gas-phase working medium 180.

With reference to FIG. 1, in an implementation, the evaporation channel 111 is a vertical channel gradually widening from bottom to top.

It can be understood that the liquid-phase working medium 170 absorbs heat and boils in the evaporation channel 111, to generate the gas-phase working medium 180 from bottom to top. Due to high pressure at a bottom portion, evaporation intensity increases from bottom to top, and the evaporation channel 111 arranged as a vertical channel which gradually widens from bottom to top can match the evaporation intensity of the gas-phase working medium 180, which further reduces the flow resistance of the gas-phase working medium 180.

With reference to FIG. 2, in an implementation, the circumferential loop channel 110 further includes a condensation channel 112 arranged on the far heat source side, and a volume of the condensation channel 112 accounts for at least half of a total volume of the circumferential loop channel 110.

It can be understood that the condensation channel 112 is located on the far heat source side of the heat dissipation tooth plate 100 and is configured for condensation of the liquid-phase working medium 170, and the volume of the condensation channel 112 accounting for at least half of the total volume of the circumferential loop channel 110 can fully ensure a condensation space for heat dissipation and match a liquid level raising requirement inside the circumferential loop channel 110.

With reference to FIG. 2, in an implementation, the circumferential loop channel 110 further includes a liquid return channel 113 and a liquid replenishment channel 114. The liquid return channel 113 is arranged on the far heat source side and is located below the condensation channel 112. The liquid replenishment channel 114 is arranged at a bottom portion of the heat dissipation tooth plate 100 and is located between the liquid return channel 113 and the evaporation channel 111.

The evaporation channel 111, the condensation channel 112, the liquid return channel 113, and the liquid replenishment channel 114 are connected in sequence to form the circumferential loop channel 110.

It can be understood that the liquid-phase working medium 170 in the circumferential loop channel 110 absorbs heat and evaporates in the evaporation channel 111, so that gas generated is discharged upwards, which flows to the condensation channel 112 on the far heat source side and condenses into the liquid-phase working medium 170, and then the liquid-phase working medium 170 flows to be below the condensation channel 112, that is, flows into the liquid return channel 113. Then, the liquid-phase working medium 170 flows through the liquid return channel 113 to the bottom portion of the heat dissipation tooth plate 100, that is, flows into the liquid replenishment channel 114, and finally returns to the evaporation channel 111 and continues to absorb heat and evaporate. In this way, the phase-change working medium forms directional two-phase circulation in the circumferential loop channel 110.

In an implementation, the two-phase heat dissipation fin further includes:
a liquid absorbing wick 130, vertically arranged on a side wall of the evaporation channel 111.

It can be understood that, with the liquid absorbing wick 130 vertically arranged on the side wall of the evaporation channel 111, the evaporation channel 111 can be kept moist, to prevent the evaporation channel 111 from dry burning due to lack of liquid.

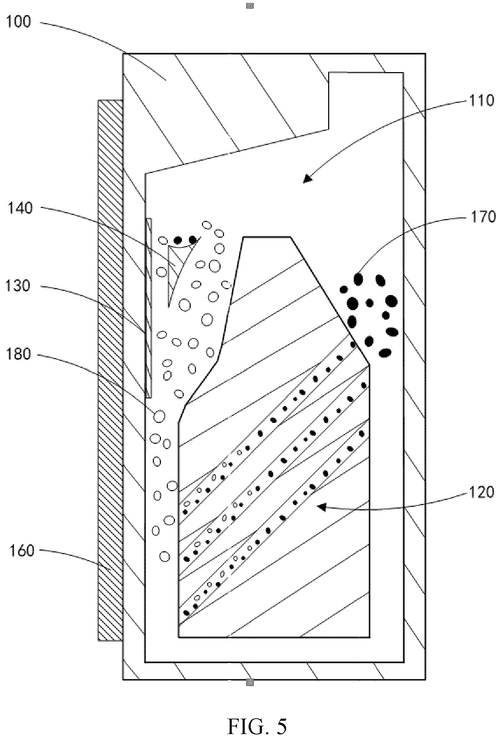

Further, with reference to FIG. 5, in some other embodiments, the liquid absorbing wick 130 is arranged on an upper side wall on the near heat source side in the evaporation channel 111. It can be understood that, with the liquid absorbing wick 130 arranged vertically on the upper side wall on the near heat source side in the evaporation channel 111, the liquid level in the evaporation channel 111 can be raised, such that the high-level evaporation channel 111 is kept moist, which effectively reduces temperature of the near heat source side of the heat dissipation tooth plate 100, and improves heat dissipation efficiency of an upper portion of the fin.

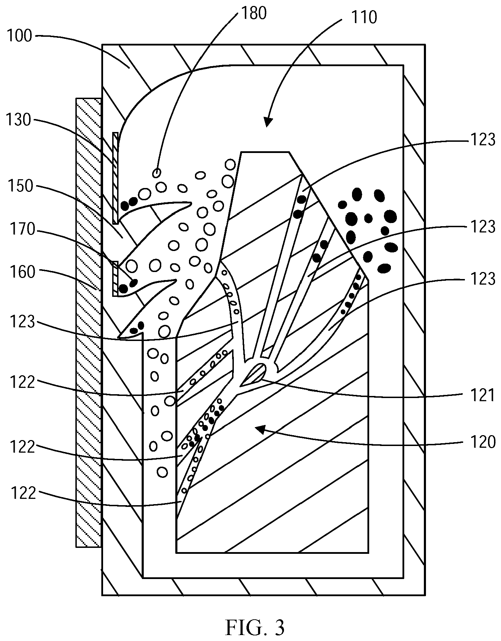

With reference to FIG. 1 and FIG. 3, according to the invention, the splitting channel 120 includes a splitting center 121 and a plurality of splitting branches extending from the splitting center 121.

It can be understood that the splitting center 121 and the plurality of splitting branches extending from the splitting center 121 form the splitting channel 120, and the splitting channel 120 extends upwards from the lower portion of the evaporation channel 111 to the upper portion of the evaporation channel 111 or extends to a position beyond the evaporation channel 111. Therefore, the arrangement of the splitting branches includes the following cases.

In some embodiments, the splitting branches are connected to the lower portion of the evaporation channel 111 and the upper portion of the evaporation channel 111. Such an arrangement of the splitting branches can increase discharge paths of the gas-phase working medium 180 and reduce discharge resistance of the gas-phase working medium 180.

In some embodiments, the splitting branches are connected to the lower portion of the evaporation channel 111 and a position beyond the evaporation channel 111. Such an arrangement of the splitting branches can increase discharge paths of the gas-phase working medium 180, reduce discharge resistance of the gas-phase working medium 180, and increase return paths of the liquid-phase working medium 170.

In some embodiments, the splitting branches are connected to the lower portion of the evaporation channel 111, the upper portion of the evaporation channel 111, and the position beyond the evaporation channel 111. Such an arrangement of the splitting branches can increase discharge paths of the gas-phase working medium 180, reduce discharge resistance of the gas-phase working medium 180, and increase return paths of the liquid-phase working medium 170. Further, the splitting branches are connected to the lower portion of the evaporation channel 111, the upper portion of the evaporation channel 111, and the position beyond the evaporation channel 111, which can implement gas-liquid separation in the splitting channel 120, so that the discharge paths of the gas-phase working medium 180 and the return paths of the liquid-phase working medium 170 can be more clearly directed, thereby improving two-phase circulation efficiency.

With reference to FIG. 1 and FIG. 3, in an implementation, the splitting branches include a first splitting branch 122 and a second splitting branch 123. The first splitting branch 122 is connected to the lower portion of the evaporation channel 111. The second splitting branch 123 is connected to the upper portion of the evaporation channel 111 or the position beyond the evaporation channel 111.

It can be understood that "the second splitting branch 123 is connected to the upper portion of the evaporation channel 111 or the position beyond the evaporation channel 111" includes the following cases.

In some embodiments, the second splitting branch 123 is connected only to the position beyond the evaporation channel 111.

In some embodiments, the second splitting branch 123 is connected only to the upper portion of the evaporation channel 111.

In some embodiments, as shown in FIG. 3, a plurality of second splitting branches 123 are arranged, and the plurality of second splitting branches 123 are connected to the upper portion of the evaporation channel 111 and the position beyond the evaporation channel 111.

In short, the first splitting branch 122 is connected to the lower portion of the evaporation channel 111, and the second splitting branch 123 is connected to at least one of the upper portion of the evaporation channel 111 and the position beyond the evaporation channel 111.

In an implementation, as shown in FIG. 2, the circumferential loop channel 110 includes an evaporation channel 111, a condensation channel 112, a liquid return channel 113, and a liquid replenishment channel 114. The splitting branches include a first splitting branch 122 and a second splitting branch 123, where the first splitting branch 122 is connected to the lower portion of the evaporation channel 111, and the second splitting branch 123 is connected to the upper portion of the evaporation channel 111 or the position beyond the evaporation channel 111.

In some embodiments, the first splitting branch 122 is connected to the lower portion of the evaporation channel 111, and the plurality of second splitting branches 123 are connected to the condensation channel 112 and the liquid return channel 113.

It can be understood that the splitting branches include the first splitting branch 122 for connecting to the lower portion of the evaporation channel 111 and the plurality of second splitting branches 123 for connecting to the evaporation channel 111, the condensation channel 112, and the liquid return channel 113, which increases discharge paths of the gas-phase working medium 180 and return paths of the liquid-phase working medium 170, and can accelerate discharge of the gas-phase working medium 180 when the liquid-phase working medium 170 absorbs heat from the evaporation channel 111 on the near heat source side to evaporate into the gas-phase working medium 180, and then accelerate liquid return and replenishment of the liquid-phase working medium 170 to the lower portion of the evaporation channel 111 when the gas-phase working medium 180 flows to the condensation channel 112 on the far heat source side and condenses into the liquid-phase working medium 170.

In some embodiments, as shown in FIG. 3, the first splitting branch 122 is connected to the lower portion of the evaporation channel 111, and the plurality of second splitting branches 123 are connected to the upper portion of the evaporation channel 111 and the condensation channel 112.

It can be understood that the splitting branches include the first splitting branch 122 for connecting to the lower portion of the evaporation channel 111 and the second splitting branches 123 for connecting to the upper portion of the evaporation channel 111 and the condensation channel 112, which increases discharge paths of the gas-phase working medium 180 and return paths of the liquid-phase working medium 170, and can accelerate discharge of the gas-phase working medium 180 when the liquid-phase working medium 170 absorbs heat from the evaporation channel 111 on the near heat source side to evaporate into the gas-phase working medium 180, and then accelerate liquid return and replenishment of the liquid-phase working medium 170 to the lower portion of the evaporation channel 111 when the gas-phase working medium 180 flows to the condensation channel 112 on the far heat source side and condenses into the liquid-phase working medium 170. Further, with the arrangement of the second splitting branch 123 connected to the upper portion of the evaporation channel 111, the gas-phase working medium 180 and the liquid-phase working medium 170 in the splitting branches are separated, such that the discharge paths of the gas-phase working medium 180 and the return paths of the liquid-phase working medium 170 are more clearly directed, which improves two-phase circulation efficiency and increases two-phase circulation driving force of the fin, thereby improving circulation efficiency and heat dissipation efficiency of the fin.

In some embodiments, the splitting branches include a plurality of first splitting branches 122, and at least one first splitting branch 122 is connected to the splitting center 121.

It can be understood that the "at least one first splitting branch 122 is connected to the splitting center 121" means that at least one first splitting branch 122 extends from the splitting center 121.

In some embodiments, as shown in FIG. 3, the splitting branches include three first splitting branches 122. It can be understood that when the liquid-phase working medium 170 absorbs heat from the lower portion of the evaporation channel 111 and evaporates into the gas-phase working medium 180, the plurality of first splitting branches 122 in cooperation with the second splitting branch 123 can increase discharge paths of the gas-phase working medium 180 and accelerate discharge of the gas-phase working medium 180. When the gas-phase working medium 180 flows to the far heat source side and condenses into the liquid-phase working medium 170, the plurality of first splitting branches 122 in cooperation with the second splitting branch 123 connected to the condensation channel 112 or the liquid return channel 113 can increase return paths of the liquid-phase working medium 170 and accelerate liquid return and replenishment of the liquid-phase working medium 170 to the lower portion of the evaporation channel 111.

In some embodiments, the splitting branches include a plurality of second splitting branches 123 connected to the upper portion of the evaporation channel 111, and at least one second splitting branch 123 is connected to the splitting center 121.

It can be understood that the "at least one second splitting branch 123 connected to the upper portion of the evaporation channel 111 is connected to the splitting center 121" means that at least one second splitting branch 123 connected to the upper portion of the evaporation channel 111 extends from the splitting center 121.

It should be understood that the liquid-phase working medium 170 absorbs heat and boils in the lower portion of the evaporation channel 111, so that steam is generated from bottom to top. Due to high pressure at the bottom portion, evaporation intensity increases from bottom to top, and the arrangement of the plurality of second splitting branches 123 connected to the upper portion of the evaporation channel 111 can reduce discharge resistance of the steam and improve two-phase circulation efficiency.

In some embodiments, the splitting branches include a plurality of second splitting branches 123 connected to the condensation channel 112 or the liquid return channel 113, and at least one second splitting branch 123 is connected to the splitting center 121.

It can be understood that the "at least one second splitting branch 123 connected to the condensation channel 112 or the liquid return channel 113 is connected to the splitting center 121" means that at least one second splitting branch 123 connected to the condensation channel 112 or the liquid return channel 113 extends from the splitting center 121.

In some embodiments, as shown in FIG. 3, the splitting branches include three second splitting branches 123 connected to the condensation channels 112, and the three second splitting branches 123 are all connected to the splitting center 121. It can be understood that when the gas-phase working medium 180 flows to the condensation channel 112 on the far heat source side and condenses into the liquid-phase working medium 170, the three second splitting branches 123 connected to the condensation channel 112 in cooperation with the first splitting branch 122 can increase return paths of the liquid-phase working medium 170 and accelerate liquid return and replenishment of the liquid-phase working medium 170 to the lower portion of the evaporation channel 111.

It should be noted that, according to an actual situation, those having ordinary skills in the art may set the number, size, and the like of the first splitting branch 122 and the second splitting branch 123, and select any number of first splitting branches 122 and any number of second splitting branches 123 to be combined to form the splitting channel 120, which are not limited in this embodiment of the present disclosure.

With reference to FIG. 3, in an implementation, the splitting center 121 is a one-way flow valve structure configured to separate the gas-phase working medium 180 and the liquid-phase working medium 170 in the splitting branches.

It can be understood that the gas-phase working medium 180 enters the splitting channel 120 from the first splitting branch 122, and is directionally split at the splitting center 121. The gas-phase working medium 180 has a small pressure, and therefore is directionally discharged from the second splitting branch 123 connected to the upper portion of the evaporation channel 111 after flowing through the splitting center 121 of the one-way flow valve structure. The liquid-phase working medium 170 enters the splitting channel 120 from the second splitting branch 123 connected to a position beyond the evaporation channel 111. The liquid-phase working medium 170 has a larger pressure than the gas-phase working medium 180, and therefore is directionally discharged from the first splitting branch 122 connected to the lower portion of the evaporation channel 111 after flowing through the splitting center 121 of the one-way flow valve structure, to perform liquid replenishment to the lower portion of the evaporation channel 111. With the arrangement of splitting center 121 of the one-way flow valve structure, the gas-phase working medium 180 and the liquid-phase working medium 170 are directionally split, thereby reducing obstruction of the gas-phase working medium 180 flowing upwards to the returning liquid-phase working medium 170, and improving two-phase circulation efficiency.

In some embodiments, the splitting center 121 is an annular splitting pipe surrounded in a drop shape.

In some embodiments, as shown in FIG. 3, the splitting center 121 is an annular splitting pipe surrounded in a drop shape, which has a tail corresponding to the first splitting branches 122 and a head from which the second splitting branches 123 extend.

It should be understood that the splitting center 121 is a one-way flow valve structure, which may be surrounded in a drop shape, a wing shape, or other pipe shapes with a central splitting function, which is not specifically limited in this embodiment of the present disclosure.

With reference to FIG. 5, in some embodiments, the two-phase heat dissipation fin further includes:
a liquid storage structure 140, arranged in the upper portion of the evaporation channel 111.

It can be understood that, with the liquid storage structure 140 arranged in the upper portion of the evaporation channel 111, when a part of the gas-phase working medium 180 that absorbs heat to evaporate in the lower portion of the evaporation channel 111 condenses and accumulates at the liquid storage structure 140, the upper portion of the evaporation channel 111 can be kept moist. Alternatively, when the liquid-phase working medium 170 inside the evaporation channel 111 violently boils and transforms into the gas-phase working medium 180, the gas-phase working medium 180 drives a part of the liquid-phase working medium 170 to flow upwards. In this case, the part of the liquid-phase working medium 170 that flows upwards is brought into the liquid storage structure 140 by the gas-phase working medium 180 to form local infiltration, such that the liquid level is raised by the liquid-phase working medium 170 that flows upwards, and the liquid-phase working medium 170 that flows upwards is collected by the liquid storage structure 140 to alleviate a dry burning problem at a top portion of the two-phase heat dissipation fin.

With reference to FIG. 1 and FIG. 3, in an implementation, the liquid storage structure 140 is a stepped platform 150, and the stepped platform 150 is inclined toward a direction of gravity from the far heat source side to the near heat source side.

It can be understood that, with the stepped platform 150 arranged in the upper portion of the evaporation channel 111 and the stepped platform 150 inclined in the direction of gravity from the far heat source side to the near heat source side, a part of the gas-phase working medium 180 that absorbs heat and evaporates in the lower portion of the evaporation channel 111 condenses at the stepped platform 150, and liquid flows downwards along an upper edge of the stepped platform 150 and accumulates; or a part of the liquid-phase working medium 170 is driven to flow upwards by the gas-phase working medium 180 which evaporates due to heat absorption and flows upwards, condenses and accumulates on the stepped platform 150. In this way, the upper portion of the evaporation channel 111 can be kept moist.

In some embodiments, as shown in FIG. 1, the stepped platform 150 is arranged in the upper portion of the evaporation channel 111 and is formed by press-fitting the heat dissipation tooth plate 100. The upper and lower edges of the stepped platform 150 have specific curvature to guide the returning liquid-phase working medium 170 and the discharged gas-phase working medium 180, to improve two-phase circulation efficiency and heat dissipation efficiency.

In some embodiments, as shown in FIG. 1, the two-phase heat dissipation fins include a plurality of stepped platforms 150 extending from the near heat source side to the far heat source side, and each of the stepped platforms 150 gradually expands from bottom to top. Such an arrangement can more fully guide the returning liquid-phase working medium 170 and the discharged gas-phase working medium 180.

It should be noted that those having ordinary skills in the art may set a number, size, shape, and the like of the stepped platform 150 according to an actual situation, which is not limited in this embodiment of the present disclosure.

In an implementation, the two-phase heat dissipation fin further includes:
a liquid absorbing wick 130, arranged on the liquid storage structure 140.

It can be understood that, with the liquid absorbing wick 130 arranged on the liquid storage structure 140, liquid accumulating on the liquid storage structure 140 can be absorbed, such that the upper portion of the evaporation channel 111 on the near heat source side can be kept moist for a long time.

In some embodiments, as shown in FIG. 1, the liquid absorbing wick 130 is vertically arranged on a side wall of the stepped platform 150.

It can be understood that, with the liquid absorbing wick 130 vertically arranged on the side wall of the stepped platform 150, liquid accumulating on the upper edge of the stepped platform 150 can be absorbed and raised, and spread flat on the side wall on the near heat source side. This further prevents the upper portion of the evaporation channel 111 from dry burning due to lack of liquid.

With reference to FIG. 4, in an implementation, a top area of the heat dissipation tooth plate 100 on the near heat source side is a solid press-fit structure.

It can be understood that a large amount of high-temperature gas-phase working medium 180 may accumulate in the top area of the heat dissipation tooth plate 100 on the near heat source side, making it difficult to dissipate heat. Therefore, the top area of the heat dissipation tooth plate 100 on the near heat source side is arranged as a solid press-fit structure, that is, the top area has no channel coverage, to reduce deterioration of heat dissipation at a top portion of the heat dissipation tooth caused by accumulation of the gas-phase working medium 180 with high temperature in the top area.

In some embodiments, the top area of the heat dissipation tooth plate 100 on the near heat source side is a pure aluminum plate structure without channel coverage.

In an implementation, a lower part of the condensation channel 112 extends along the direction of gravity to the far heat source side, to guide the liquid-phase working medium 170 to return to the liquid return channel 113 and accelerate the return of the liquid-phase working medium 170.

In an implementation, the two-phase heat dissipation fin may be press-fit in multiple local areas within a range of the condensation channel 112, and fin surfaces on two sides of the local press-fit areas are closely connected through a hot pressing process, thereby improving a pressure bearing capacity of the circumferential loop channel 110 around.

The following embodiment describes a two-phase heat dissipation fin according to the present disclosure.

As shown in FIG. 2 and FIG. 3, the two-phase heat dissipation fin according to the present disclosure includes a heat dissipation tooth plate 100, a circumferential loop channel 110 and a splitting channel 120. A left side of the heat dissipation tooth plate 100 is heated by a heat source 160 and is a near heat source side, and a right side of the heat dissipation tooth plate 100 is a far heat source side. The circumferential loop channel 110 is arranged on the heat dissipation tooth plate 100, and is filled with a phase-change working medium. A liquid level of the phase-change working medium is higher than half of a height of the heat dissipation tooth plate 100. An evaporation channel 111, a condensation channel 112, a liquid return channel 113, and a liquid replenishment channel 114 are connected in sequence to form the circumferential loop channel 110. The splitting channel 120 includes a splitting center 121 of a one-way flow structure, and a plurality of first splitting branches 122 and a plurality of second splitting branches 123 extending from the splitting center 121. The first splitting branches 122 are connected to a lower portion of the evaporation channel 111, the second splitting branches 123 are connected to an upper portion of the evaporation channel 111 and the condensation channel 112.

The phase-change working medium absorbs heat and boils in the evaporation channel 111, so that hot steam is generated from bottom to top, and flows upwards along the evaporation channel 111 which gradually expands vertically. In addition, in the lower portion of the evaporation channel 111, a part of the hot steam enters the splitting channel 120 through the plurality of first splitting branches 122, and is directionally discharged from the second splitting branches 123 through the splitting center 121 of the one-way flow valve structure. When the hot steam flows to the upper portion of the evaporation channel 111, a part of the hot steam condenses into condensate. The condensate either flows along a lower edge of a stepped platform 150 to an upper edge of a stepped platform 150 below, or flows along an upper edge of a stepped platform 150 in a direction of gravity toward the near heat source side to accumulate. The condensate returned absorbs heat and evaporates into steam again, and the steam is discharged to the condensation channel 112 along the upper edge of the stepped platform 150. When liquid accumulates on the stepped platform 150, a liquid absorbing wick 130 vertically arranged on a side wall of the stepped platform 150 can raise the accumulating liquid and spread the accumulating liquid flat on a heating edge to keep the high-level evaporation channel 111 moist, which reduces temperature of the fin on the near heat source side and improves heat dissipation efficiency of an upper portion of the fin.

The hot steam flows upwards due to buoyancy to the condensation channel 112 on the far heat source side, and cools and condenses into condensate, which returns to the liquid return channel 113, and flows back to the evaporation channel 111 through the liquid replenishment channel 114. In addition, a part of the condensate flows into the splitting channel 120 through the plurality of second splitting branches 123 connected to the condensation channel 112, and directionally flows out of the first splitting branches 122 through the splitting center 121 of the one-way flow valve structure, to finally perform liquid replenishment to the lower portion of the evaporation channel 111. In this way, efficient directional two-phase self-driven circulation of the internal phase-change working medium of the two-phase heat dissipation fin in a heating process is implemented, which significantly improves circulation efficiency and heat dissipation efficiency of the fin.

An embodiment of the present disclosure provides a heat sink. The heat sink includes the two-phase heat dissipation fin according to the foregoing embodiments of the present disclosure. For the structure and beneficial effects of the two-phase heat dissipation fin, reference may be made to the foregoing embodiments. Details are not described herein again.

The embodiments of the present disclosure provide a two-phase heat dissipation fin and a heat sink. The two-phase heat dissipation fin includes a heat dissipation tooth plate, a circumferential loop channel, and a splitting channel. The heat dissipation tooth plate has a near heat source side and a far heat source side. The circumferential loop channel is arranged on the heat dissipation tooth plate, is filled with a phase-change working medium, and includes an evaporation channel arranged on the near heat source side. The phase-change working medium absorbs heat from the evaporation channel on the near heat source side and condenses on the far heat source side, and the phase-change working medium forms directional two-phase circulation in the circumferential loop channel. The splitting channel extends obliquely upwards from a lower portion of the evaporation channel to an upper portion of the evaporation channel or extends to a position beyond the evaporation channel. In the embodiments of the present disclosure, with the arrangement of the circumferential loop channel and the splitting channel, stable gas-liquid circulation and strong circulation driving force are formed inside the fin, directional two-phase self-driven circulation of the fin is implemented, and circulation efficiency and cooling efficiency of the fin are improved.

## Claims

1. A two-phase heat dissipation fin, comprising:
a heat dissipation tooth plate (100), having a near heat source side and a far heat source side;
a circumferential loop channel (110), arranged on the heat dissipation tooth plate (100), wherein the circumferential loop channel (110) is filled with a phase-change working medium, and comprises an evaporation channel (111) arranged on the near heat source side; and
a splitting channel (120), extending obliquely upwards from a lower portion of the evaporation channel (111) to an upper portion of the evaporation channel (111) or extends to a position beyond the evaporation channel (111);
**characterized in that**,
the splitting channel (120) comprises a splitting center (121) and a plurality of splitting branches extending from the splitting center (121).

2. The two-phase heat dissipation fin of claim 1, wherein the evaporation channel (111) is a vertical channel gradually widening from bottom to top.

3. The two-phase heat dissipation fin of claim 1, wherein the circumferential loop channel (110) further comprises a condensation channel (112) arranged on the far heat source side, and a volume of the condensation channel (112) accounts for at least half of a total volume of the circumferential loop channel (110).

4. The two-phase heat dissipation fin of claim 3, wherein the circumferential loop channel (110) further comprises a liquid return channel (113) and a liquid replenishment channel (114), the liquid return channel (113) is arranged on the far heat source side and is located below the condensation channel (112), and the liquid replenishment channel (114) is arranged at a bottom portion of the heat dissipation tooth plate (100) and is located between the liquid return channel (113) and the evaporation channel (111); and
the evaporation channel (111), the condensation channel (112), the liquid return channel (113), and the liquid replenishment channel (114) are connected in sequence to form the circumferential loop channel (110).

5. The two-phase heat dissipation fin of claim 1, further comprising:
a liquid absorbing wick (130), vertically arranged on a side wall of the evaporation channel (111).

6. The two-phase heat dissipation fin of claim 1, wherein the splitting branches comprise a first splitting branch (122) and a second splitting branch (123), the first splitting branch (122) is connected to the lower portion of the evaporation channel (111), and the second splitting branch (123) is connected to the upper portion of the evaporation channel (111) or is connected to the position beyond the evaporation channel (111).

7. The two-phase heat dissipation fin of claim 1, wherein the splitting center (121) is a one-way flow valve structure configured to separate a gas-phase working medium (180) and a liquid-phase working medium (170) in the splitting branches.

8. The two-phase heat dissipation fin of claim 7, wherein the splitting center (121) is an annular splitting pipe surrounded in a drop shape.

9. The two-phase heat dissipation fin of claim 1, further comprising:
a liquid storage structure (140), arranged in the upper portion of the evaporation channel (111).

10. The two-phase heat dissipation fin of claim 9, wherein the liquid storage structure (140) is a stepped platform (150) inclined toward a direction of gravity from the far heat source side to the near heat source side.

11. The two-phase heat dissipation fin of claim 9, further comprising:
a liquid absorbing wick (130), arranged on the liquid storage structure (140).

12. The two-phase heat dissipation fin of claim 1, wherein a top area of the heat dissipation tooth plate (100) on the near heat source side is a solid press-fit structure.

13. A heat sink, comprising the two-phase heat dissipation fin of any of claims 1 to 12.

## Patentansprüche

1. Zweiphasen-Wärmeableitungsrippe, aufweisend:
eine Wärmeableitungszahnplatte (100), die eine wärmequellennahe Seite und eine wärmequellenferne Seite aufweist;
einen umlaufenden Schleifenkanal (110), der auf der Wärmeableitungszahnplatte (100) angeordnet ist, wobei der umlaufende Schleifenkanal (110) mit einem Phasenwechsel-Arbeitsmedium gefüllt ist und einen Verdampfungskanal (111) umfasst, der auf der wärmequellennahen Seite angeordnet ist; und
einen Teilungskanal (120), der sich schräg nach oben von einem unteren Abschnitt des Verdampfungskanals (111) zu einem oberen Abschnitt des Verdampfungskanals (111) erstreckt oder sich zu einer Position über den Verdampfungskanal (111) hinaus erstreckt;
**dadurch gekennzeichnet, dass**
der Teilungskanal (120) ein Teilungszentrum (121) und eine Vielzahl von Teilungszweigen umfasst, die sich von dem Teilungszentrum (121) erstrecken.

2. Zweiphasen-Wärmeableitungsrippe nach Anspruch 1, wobei der Verdampfungskanal (111) ein vertikaler Kanal ist, der sich von unten nach oben allmählich verbreitert.

3. Zweiphasen-Wärmeableitungsrippe nach Anspruch 1, wobei der umlaufende Schleifenkanal (110) ferner einen Kondensationskanal (112) umfasst, der auf der wärmequellenfernen Seite angeordnet ist, und ein Volumen des Kondensationskanals (112) mindestens die Hälfte eines Gesamtvolumens des umlaufenden Schleifenkanals (110) ausmacht.

4. Zweiphasen-Wärmeableitungsrippe nach Anspruch 3, wobei der umlaufende Schleifenkanal (110) ferner einen Flüssigkeitsrückführkanal (113) und einen Flüssigkeitsnachfüllkanal (114) umfasst, der Flüssigkeitsrückführkanal (113) auf der wärmequellenfernen Seite angeordnet ist und sich unter dem Kondensationskanal (112) befindet, und der Flüssigkeitsnachfüllkanal (114) an einem unteren Abschnitt der Wärmeableitungszahnplatte (100) angeordnet ist und sich zwischen dem Flüssigkeitsrückführkanal (113) und dem Verdampfungskanal (111) befindet; und der Verdampfungskanal (111), der Kondensationskanal (112), der Flüssigkeitsrückführkanal (113) und der Flüssigkeitsnachfüllkanal (114) nacheinander verbunden sind, um den umlaufenden Schleifenkanal (110) zu bilden.

5. Zweiphasen-Wärmeableitungsrippe nach Anspruch 1, ferner umfassend: einen flüssigkeitsabsorbierenden Docht (130), der vertikal an einer Seitenwand des Verdampfungskanals (111) angeordnet ist.

6. Zweiphasen-Wärmeableitungsrippe nach Anspruch 1, wobei die Teilungszweige einen ersten Teilungszweig (122) und einen zweiten Teilungszweig (123) umfassen, der erste Teilungszweig (122) mit dem unteren Abschnitt des Verdampfungskanals (111) verbunden ist und der zweite Teilungszweig (123) mit dem oberen Abschnitt des Verdampfungskanals (111) verbunden ist oder mit der Position über den Verdampfungskanal (111) hinaus verbunden ist.

7. Zweiphasen-Wärmeableitungsrippe nach Anspruch 1, wobei das Teilungszentrum (121) eine Einweg-Strömungsventilstruktur ist, die konfiguriert ist, um ein Gasphasen-Arbeitsmedium (180) und ein Flüssigphasen-Arbeitsmedium (170) in den Teilungszweigen zu trennen.

8. Zweiphasen-Wärmeableitungsrippe nach Anspruch 7, wobei das Teilungszentrum (121) ein ringförmiges Teilungsrohr ist, das in einer Tropfenform umgeben ist.

9. Zweiphasen-Wärmeableitungsrippe nach Anspruch 1, ferner umfassend: eine Flüssigkeitsspeicherstruktur (140), die in dem oberen Abschnitt des Verdampfungskanals (111) angeordnet ist.

10. Zweiphasen-Wärmeableitungsrippe nach Anspruch 9, wobei die Flüssigkeitsspeicherstruktur (140) eine abgestufte Plattform (150) ist, die in Richtung einer Schwerkraftrichtung von der wärmequellenfernen Seite zu der wärmequellennahen Seite geneigt ist.

11. Zweiphasen-Wärmeableitungsrippe nach Anspruch 9, ferner umfassend:
einen flüssigkeitsabsorbierenden Docht (130), der auf der Flüssigkeitsspeicherstruktur (140) angeordnet ist.

12. Zweiphasen-Wärmeableitungsrippe nach Anspruch 1, wobei ein oberer Bereich der Wärmeableitungszahnplatte (100) auf der wärmequellennahen Seite eine massive Presspassungsstruktur ist.

13. Kühlkörper, umfassend die Zweiphasen-Wärmeableitungsrippe nach einem der Ansprüche 1 bis 12.

## Revendications

1. Ailette de dissipation thermique à deux phases, comprenant :
une plaque de dissipation thermique dentée (100), ayant un côté proche de la source de chaleur et un côté distant de la source de chaleur ;
un canal en boucle circonférentielle (110), disposé sur la plaque de dissipation thermique dentée (100), le canal en boucle circonférentielle (110) étant rempli d'un milieu de travail à changement de phase, et comprenant un canal d'évaporation (111) disposé sur le côté proche de la source de chaleur ; et
un canal de séparation (120), s'étendant obliquement vers le haut depuis une partie inférieure du canal d'évaporation (111) jusqu'à une partie supérieure du canal d'évaporation (111) ou s'étendant jusqu'à une position au-delà du canal d'évaporation (111) ;
**caractérisée en ce que**
le canal de séparation (120) comprend un centre de séparation (121) et une pluralité de branches de séparation s'étendant depuis le centre de séparation (121).

2. Ailette de dissipation thermique à deux phases de la revendication 1, dans laquelle le canal d'évaporation (111) est un canal vertical s'élargissant progressivement de bas en haut.

3. Ailette de dissipation thermique à deux phases de la revendication 1, dans laquelle le canal en boucle circonférentielle (110) comprend en outre un canal de condensation (112) disposé sur le côté distant de la source de chaleur, et un volume du canal de condensation (112) représente au moins la moitié d'un volume total du canal en boucle circonférentielle (110).

4. Ailette de dissipation thermique à deux phases de la revendication 3, dans laquelle le canal en boucle circonférentielle (110) comprend en outre un canal de retour de liquide (113) et un canal de réapprovisionnement en liquide (114), le canal de retour de liquide (113) est disposé sur le côté distant de la source de chaleur et se situe en dessous du canal de condensation (112), et le canal de réapprovisionnement en liquide (114) est disposé au niveau d'une partie inférieure de la plaque de dissipation thermique dentée (100) et se situe entre le canal de retour de liquide (113) et le canal d'évaporation (111) ; et
le canal d'évaporation (111), le canal de condensation (112), le canal de retour de liquide (113) et le canal de réapprovisionnement en liquide (114) sont raccordés en séquence pour former le canal en boucle circonférentielle (110).

5. Ailette de dissipation thermique à deux phases de la revendication 1, comprenant en outre :
une mèche absorbant les liquides (130), disposée verticalement sur une paroi latérale du canal d'évaporation (111).

6. Ailette de dissipation thermique à deux phases de la revendication 1, dans laquelle les branches de séparation comprennent une première branche de séparation (122) et une deuxième branche de séparation (123), la première branche de séparation (122) est raccordée à la partie inférieure du canal d'évaporation (111), et la deuxième branche de séparation (123) est raccordée à la partie supérieure du canal d'évaporation (111) ou est raccordée à la position au-delà du canal d'évaporation (111).

7. Ailette de dissipation thermique à deux phases de la revendication 1, dans laquelle le centre de séparation (121) est une structure de vanne à écoulement unidirectionnel conçue pour séparer un milieu de travail en phase gazeuse (180) et un milieu de travail en phase liquide (170) dans les branches de séparation.

8. Ailette de dissipation thermique à deux phases de la revendication 7, dans laquelle le centre de séparation (121) est un tube de séparation annulaire entouré en forme de goutte.

9. Ailette de dissipation thermique à deux phases de la revendication 1, comprenant en outre :
une structure de stockage de liquide (140), disposée dans la partie supérieure du canal d'évaporation (111).

10. Ailette de dissipation thermique à deux phases de la revendication 9, dans laquelle la structure de stockage de liquide (140) est une plate-forme en gradins (150) inclinée dans la direction de la gravité depuis le côté distant de la source de chaleur jusqu'au côté proche de la source de chaleur.

11. Ailette de dissipation thermique à deux phases de la revendication 9, comprenant en outre :
une mèche absorbant les liquides (130), disposée sur la structure de stockage de liquide (140).

12. Ailette de dissipation thermique à deux phases de la revendication 1, dans laquelle une zone supérieure de la plaque de dissipation thermique dentée (100) sur le côté proche de la source de chaleur est une structure pleine montée en force.

13. Dissipateur thermique, comprenant l'ailette de dissipation thermique à deux phases de l'une quelconque des revendications 1 à 12.
